# EUROPEAN PATENT SPECIFICATION

(11) **EP 3 077 219 B1**
(45) Date of publication and mention of the grant of the patent: **04.07.2018**
(21) Application number: 14828533.1
(22) Date of filing: 04.12.2014
(51) Int. Cl.: B60C 5/14, B60C 1/00

(54) **TYRE COMPRISING A GRAPHITE OR GRAPHENE COVER FILM DEPOSITED ON AN INNER-LAYER SURFACE**
REIFEN MIT EINER GRAPHIT- ODER GRAPHENDECKSCHICHT AUF EINER INNENSCHICHTFLÄCHE
PNEUMATIQUE COMPRENANT UN FILM DE REVÊTEMENT EN GRAPHITE OU EN GRAPHÈNE DÉPOSÉE SUR UNE SURFACE DE COUCHE INTÉRIEURE

(30) Priority: 04.12.2013 IT RM20130671
(43) Date of publication of application: 12.10.2016
(73) Proprietor: Bridgestone Corporation, Tokyo 104-8340 (JP)
(72) Inventor: FORTE, Gianluca, I-00156 Roma (IT); FIORENZA, Paolo, I-00156 Roma (IT); PEZZULLO, Giuseppe, I-00128 Roma (IT)
(74) Representative: Marchetti, Alessio
(86) International application number: PCT/IB2014/066599
(87) International publication number: WO 2015/083119

(56) References cited:
- WO-A1-2011/131560

## Description

### TECHNICAL FIELD

The present invention relates to a tyre comprising a graphite or graphene cover film on an inner layer.

Here and hereinafter, the term 'inner layer' is intended to mean a layer facing the inner cavity of a tubeless tyre carcass; and the term 'inner-layer inner surface' to mean the surface of the inner layer facing the inner cavity.

The inner layer normally amounts to the innerliner layer, which is made of rubber substantially impermeable to air and which is used in tyres to maintain the air pressure inside the inner cavity.

The innerliner also serves to confine oxygen, to prevent it from spreading inside the compounds the tyre parts are made of, and so degrading the tyre parts.

One solution to this problem is to increase the thickness of the innerliner to form a better oxygen barrier, but this has the drawback of inevitably increasing both rolling resistance and manufacturing cost.

Innerliner compounds normally have an isobutyl rubber matrix.

### BACKGROUND ART

As is known, the tyre industry needs to produce innerliners that are as thin as possible, but without impairing performance in terms of impermeability. Reducing the thickness of the innerliner mainly has the effect of reducing the weight of the tyre as a whole and therefore rolling resistance.

Patent Applications JP2001-509111 and JP2013-103412 describe the use of a metal film covering the free surface of the innerliner to improve its impermeability properties and so enable a reduction in thickness.

WO2011/131560 discloses an inflatable object provided with an inflating gas-tight layer, said layer comprises an elastomer composition comprising also a lamellar filler in particular selected from graphites and phyllosilicates. The Applicant has developed a better, alternative solution to those described above.

### DISCLOSURE OF INVENTION

One object of the present invention is a tyre comprising a rubber inner layer facing the inner cavity of the carcass; said tyre being characterized by comprising a cover film made entirely of graphite or graphene and deposited on a surface of said inner layer wherein the inner layer is an innerliner.

Preferably, the cover film is located on an inner surface of the inner layer.

Said cover film is preferably 1 mm thick or less, and more preferably 30 µm thick or less.

A further object of the present invention is use of graphite or graphene deposited on a surface (6) of a rubber inner layer (5) of a tyre as cover film (7) made entirely of graphite or graphene wherein the inner layer is an innerliner.

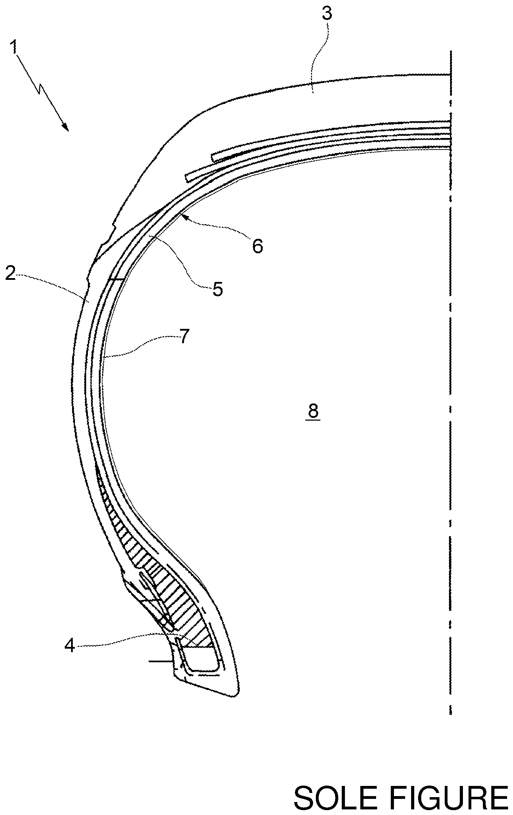

### BRIEF DESCRIPTION OF THE DRAWING

For a clearer understanding of the present invention, the following are purely non-limiting examples with the aid of the attached drawing, which shows a partial section of a tyre in accordance with one embodiment of the present invention.

### BEST MODE FOR CARRYING OUT THE INVENTION

### EXAMPLES

A graphite cover film was deposited on a surface of a cured standard innerliner compound specimen.

Table I shows the composition in phr of the innerliner compound.

**TABLE I**

| | |
|---|---|
| Halobutyl rubber | 100 |
| Carbon black | 50 |
| Clay | 40 |
| Stearic acid | 1 |
| Zinc oxide | 2 |
| Resin | 2.5 |
| Oil | 10 |
| Sulphur | 1 |
| Accelerants | 2 |

The film was deposited using the sputtering technique (SPI Supplies® Module Carbon Coater) and a carbon fibre filament (2 mm thick SPI Supplies® Carbon Fiber), and applying a 6 volt potential difference, with a 0.4 atm deposition chamber pressure. Deposition lasted 10 seconds.

This resulted in an Item A comprising a cured-rubber layer with the composition shown in Table I, and a 20 µm graphite film covering a surface of the cured-rubber layer.

The deposition technique is in no way binding as regards the protective scope of the invention, and may be other than as described above.

Item A was aged by applying 7% stretch tension for 5 minutes at 10 Hz frequency.

The resulting aged item is hereinafter referred to as Item B.

Items A and B, together with a control item (Item C), were oxygen impermeability tested at a temperature of 25°C, using a conventional apparatus, such as a MOCON® OX-TRA® (model 2/61).

Control Item C comprises the same cured-rubber layer as Item A, but with no graphite cover film.

Table II shows the impermeability test results indexed with respect to control Item C.

**TABLE II**

| Item A | Item B | Item C |
|---|---|---|
| 130 | 150 | 100 |

As shown in Table II, the impermeability results of the items in accordance with the present invention are far superior to that of the control item, which would suggest that an innerliner produced in accordance with the present invention is capable of ensuring greater impermeability than a standard innerliner represented by control Item C.

More specifically, the Item B results show the advantages in terms of oxygen impermeability of the innerliner according to the present invention are preserved even after prolonged use.

Number 1 in the attached drawing indicates a tyre as a whole. Tyre 1 comprises a carcass 2, a tread 3, and a bead 4. Carcass 2 comprises an innerliner 5. And a graphite or graphene cover film is deposited on the inner surface 6 of innerliner 5 facing the inner cavity 8 of the carcass.

Enhancing impermeability with the graphite or graphene cover film allows the innerliner to be made thinner, with all the advantages this affords in terms of weight and, therefore, rolling resistance.

Compared with the metal-film-coated innerliner solution, the graphite or graphene film in the present invention has the advantages of improving thermal stability, chemical resistance, and rubber compatibility. Moreover, compared with metal films in the known solution, the graphite or graphene film also has the advantages of being more environment-friendly, and being achievable using potentially simpler deposition techniques.

## Claims

1. A tyre (1) comprising a rubber inner layer (5) facing the inner cavity (8) of the carcass; said tyre being **characterized by** comprising a cover film (7) made entirely of graphite or graphene and deposited on a surface (6) of said inner layer (5) wherein the inner layer (5) is an innerliner.

2. A tyre as claimed in Claim 1, **characterized in that** said cover film (7) is located on an inner surface (6) of the inner layer (5).

3. A tyre as claimed in one of the foregoing Claims, **characterized in that** said cover film (7) is 1 mm thick or less.

4. A tyre as claimed in one of the foregoing Claims, **characterized in that** said cover film (7) is 30 µm thick or less.

5. Use of graphite or graphene deposited on a surface (6) of a rubber inner layer (5) of a tyre as cover film (7) made entirely of graphite or graphene wherein the inner layer (5) is an innerliner.

## Patentansprüche

1. Reifen (1) umfassend eine innere Kautschukschicht (5), die dem inneren Hohlraum (8) der Karkasse zugewandt ist; wobei der Reifen **dadurch gekennzeichnet ist, dass** er eine Deckfolie (7) umfasst, die vollständig aus Graphit oder Graphen hergestellt und auf einer Oberfläche (6) der inneren Schicht (5) aufgebracht ist, wobei die innere Schicht (5) ein Innerliner ist.

2. Reifen nach Anspruch 1, **dadurch gekennzeichnet, dass** sich die Deckfolie (7) an einer Innenfläche (6) der inneren Schicht (5) befindet.

3. Reifen nach einem der vorstehenden Ansprüche, **dadurch gekennzeichnet, dass** die Dicke der Deckfolie (7) 1 mm oder weniger beträgt.

4. Reifen nach einem der vorstehenden Ansprüche, **dadurch gekennzeichnet, dass** die Dicke der Deckfolie (7) 30 µm oder weniger beträgt.

5. Verwendung von Graphit oder Graphen, das auf eine Oberfläche (6) einer inneren Kautschukschicht (5) eines Reifens als vollständig aus Graphit oder Graphen hergestellte Deckfolie (7) aufgetragen wird, wobei die innere Schicht (5) ein Innerliner ist.

## Revendications

1. Pneumatique (1) comprenant une couche interne (5) de caoutchouc faisant face à la cavité interne (8) de la carcasse ; ledit pneumatique étant **caractérisé en ce qu'**il comprend un film de couverture (7) constitué entièrement de graphite ou de graphène et déposé sur une surface (6) de ladite couche interne (5), dans lequel la couche interne (5) est un revêtement intérieur.

2. Pneumatique selon la revendication 1, **caractérisé en ce que** ledit film de couverture (7) est situé sur une surface (6) interne de la couche interne (5).

3. Pneumatique selon l'une des revendications qui précèdent, **caractérisé en ce que** ledit film de couverture (7) a une épaisseur de 1 mm ou moins.

4. Pneumatique selon l'une des revendications qui précèdent, **caractérisé en ce que** ledit film de couverture (7) a une épaisseur de 30 µm ou moins.

5. Utilisation de graphite ou de graphène déposé sur une surface (6) d'une couche interne (5) de caoutchouc d'un pneumatique en tant que film de couverture (7) constitué entièrement de graphite ou de graphène, dans laquelle la couche interne (5) est un revêtement intérieur.
